Europäisches Patentamt

European Patent Office

Office européen des brevets

(11) Veröffentlichungsnummer: **0 349 925**
**A1**

(12) **EUROPÄISCHE PATENTANMELDUNG**

(21) Anmeldenummer: 89111987.7

(51) Int. Cl.⁴: **C23C 14/02 , C23C 28/00**

(22) Anmeldetag: 30.06.89

(30) Priorität: 04.07.88 DE 3822605

(43) Veröffentlichungstag der Anmeldung:
**10.01.90 Patentblatt 90/02**

(84) Benannte Vertragsstaaten:
**AT BE CH DE ES FR GB IT LI LU NL SE**

(71) Anmelder: **INTERATOM Gesellschaft mit beschränkter Haftung**
**Friedrich-Ebert-Strasse**
**D-5060 Bergisch-Gladbach 1(DE)**

(72) Erfinder: **Turwitt, Martin, Dr.**
**Grossenbaumer Allee 291**
**D-4100 Duisburg 28(DE)**
Erfinder: **Jung, Jürgen, Dr.**
**Barbarastrasse 3**
**D-5060 Bergisch Gladbach 1(DE)**

(74) Vertreter: **Mehl, Ernst, Dipl.-Ing. et al**
**Postfach 22 13 17**
**D-8000 München 22(DE)**

(54) Verfahren zum Beschichten von Gegenständen aus hochschmelzenden Metallen.

(57) Um die korrosionsbeständigen hochschmelzenden Metalle (Nb, Mo, Ta, W) als Substrat für eine elektrisch leitende Schicht (Au, Ag, Cu, Pt, Al, Ni) oder eine elektrisch isolierende Schicht ($Al_2O_3$, $ZrO_2$, $SiO_2$, SiC, $Si_3N_4$, $B_4C$, BN, MgO) verwenden zu können, wird erfindungsgemäß auf Gegenstände, die aus diesen Metallen hergestellt sind, zunächst eine Haftvermittlungsschicht aufgebracht, die vorzugsweise in einem PVD-Verfahren unter Sauerstoffabschluß aufgebracht wird und eine Dicke von 5 bis 500 nm aufweist. Die Haftvermittlungsschicht kann aus dem Grundmaterial selbst bestehen oder aus Ti, Zr, Cr und/oder Hf.

EP 0 349 925 A1

## Verfahren zum Beschichten von Gegenständen aus hochschmelzenden Metallen

Die vorliegende Erfindung betrifft ein Verfahren zum Beschichten eines Gegenstandes aus einem hochschmelzenden Metall mit einem Metall oder einer Keramik. Hochschmelzende Metalle, auch als Refraktärmetalle bezeichnet, z. B. Niob, Molybdän, Tantal und Wolfram weisen neben der durch ihren Namen angedeuteten ausgezeichneten Hitzebeständigkeit eine gute Korrosionsbeständigkeit gegen eine Vielzahl aggressiver Medien auf. Dies ist im wesentlichen darauf zurückzuführen, daß sich auf ihnen an der Luft eine dichte, festhaftende Oxydschicht bildet. Diese Oxydschicht wiederum ist der Grund dafür, daß auf ihnen mittels bekannter Verfahren, z. B. CVD- oder PVD-Verfahren, aufgebrachte Schichten aus anderen Stoffen nicht haften. Die Aufbringung einer solchen Schicht ist aber vielfach erforderlich, so z. B. in der Elektrotechnik, wenn das hochschmelzende Metall wegen seiner Korrosionsbeständigkeit als Substrat für eine elektrisch leitende (Metall-) Schicht oder eine isolierende (keramische) Schicht verwendet werden soll. Als weiterer Nachteil der Oxydschicht auf dem hochschmelzenden Metall wirkt sich ihr hoher elektrischer Widerstand aus, der zu elektrischen Kontaktschwierigkeiten zwischen diesem Metall und der Beschichtung führt.

Aufgabe der vorliegenden Erfindung ist die Angabe eines Verfahrens, das es gestattet, einen Gegenstand aus einem hochschmelzenden Metall je nach Wahl mit einer elektrisch leitenden oder isolierenden Oberflächenschicht zu versehen.

Die Lösung dieser Aufgabe erfolgt erfindungsgemäß dadurch, daß auf den Gegenstand zunächst unter Sauerstoffabschluß eine Haftvermittlungsschicht aufgebracht wird und erst danach die eigentlich gewünschte Schicht abgeschieden wird.

Haftvermittlungsschichten sind zwar grundsätzlich in einer Vielzahl von Anwendungsgebieten bekannt, z. B. beim Aufbau dauerhafter Farbanstriche; sie sind jedoch bislang bei der Beschichtung von hochschmelzenden Metallen nicht verwendet worden, da die Möglichkeit ihrer Anwendung auf diesem Gebiet nicht erkannt wurde.

Insbesondere wird für den zu beschichtenden Gegenstand Niob, Molybdän, Tantal und/oder Wolfram verwendet.

Als erfindungsgemäße Haftvermittlungsschicht wird vorzugsweise Niob, Molybdän, Tantal, Wolfram, Titan, Zirkon, Chrom und/oder Hafnium verwendet. Dabei kann in weiterer Ausgestaltung der Erfindung für die Haftvermittlungsschicht der gleiche Stoff verwendet werden wie für den jeweiligen zu beschichtenden Gegenstand.

Soll auf dem Grundmetall eine elektrisch leitende Schicht hergestellt werden, so wird erfindungsgemäß auf die Haftvermittlungsschicht eine Metallschicht aus Gold, Silber, Kupfer, Platin, Aluminium und/oder Nickel aufgebracht.

Demgegenüber wird zur Herstellung einer elektrisch nicht leitenden Schicht auf die Haftvermittlungsschicht vorzugsweise eine Keramikschicht aus Aluminiumoxyd, Zirkonoxyd, Siliciumoxyd, Siliciumcarbid, Siliciumnitrid, Borcarbid, Bornitrid und/oder Magnesiumoxyd aufgebracht.

Erfindungsgemäß eignet sich für das Aufbringen der Haftvermittlungsschicht insbesondere ein Lichtbogen-PVD-Verfahren, bei dem der Beschichtungsstoff aus einem Plasma auf dem Gegenstand niedergeschlagen wird. Bei einem derartigen Verfahren werden eine oder mehrere aus den gewünschten Legierungsbestandteilen bestehende Kathoden im Vakuum in einer Lichtbogenentladung verdampft; ggf. kann die Zusammensetzung der Beschichtung noch durch die Zugabe dosierter Mengen eines mit dem Plasma reagierenden Gases beeinflußt werden.

Insbesondere ein Dickenbereich für die Haftvermittlungsschicht von 5 bis 500 nm liefert sehr gute Ergebnisse. Die zu wählende Schichtdicke ist nach unten durch die Oberflächenrauhigkeit des zu beschichtenden Gegenstandes bzw. der ihn bedeckenden Oxydschicht begrenzt. Die Schicht muß eine vollständige Bedeckung sicherstellen. Nach oben ist die Schichtdicke dadurch begrenzt, daß sich in der Haftvermittlungsschicht keine Inhomogenitäten oder andere Strukturdefekte bilden sollen, die einem inneren Zerfall der Schicht Vorschub leisten könnten.

In Versuchen wurde festgestellt, daß z. B. Gold- und Platinschichten ausgezeichnet auf Niob haften, wenn auf dieses zuvor eine 50 bis 200 nm dicke Titan- oder Zirkonschicht aufgedampft wurde. Eine ebenfalls sehr gute Haftung auf Niob wurde für eine Aluminiumoxydschicht erzielt. Gleichfalls gute Ergebnisse wurden erreicht, wenn auf die Niob-Oberfläche zunächst Niob als Haftvermittlungsschicht und dann Gold als Oberflächenschicht aufgebracht wird. Ohne die Zwischenschicht aus Niob haftet das Gold nur schlecht.

### Ansprüche

1. Verfahren zum Beschichten eines Gegenstandes aus einem hochschmelzenden Metall mit einem Metall oder einer Keramik, **dadurch gekennzeichnet**, daß auf den Gegenstand zunächst unter Sauerstoffabschluß eine Haftvermittlungsschicht aufgebracht wird.

2. Verfahren nach Anspruch 1, **dadurch ge-**

kennzeichnet, daß ein Gegenstand aus Niob, Molybdän, Tantal und/oder Wolfram verwendet wird.

3. Verfahren nach Anspruch 1 oder 2, **dadurch gekennzeichnet**, daß als Haftvermittlungsschicht Niob, Molybdän, Tantal, Wolfram, Titan, Zirkon, Chrom und/oder Hafnium verwendet wird.

4. Verfahren nach Anspruch 3, **dadurch gekennzeichnet**, daß als Haftvermittlungsschicht der gleiche Stoff wie der des jeweiligen Gegenstandes verwendet wird.

5. Verfahren nach einem oder mehreren der vorhergehenden Ansprüche, **dadurch gekennzeichnet**, daß auf die Haftvermittlungsschicht eine Metallschicht aus Gold, Silber, Kupfer, Platin, Aluminium und/oder Nickel aufgebracht wird.

6. Verfahren nach einem oder mehreren der Ansprüche 1 bis 4, **dadurch gekennzeichnet**, daß auf die Haftvermittlungsschicht eine Keramikschicht aus Aluminiumoxyd, Zirkonoxyd, Siliciumoxyd, Siliciumcarbid, Siliciumnitrid, Borcarbid, Bornitrid und/oder Magnesiumoxyd aufgebracht wird.

7. Verfahren nach einem oder mehreren der vorhergehenden Ansprüche, **dadurch gekennzeichnet**, daß die Haftvermittlungsschicht aus einem Plasma auf dem Gegenstand niedergeschlagen wird.

8. Verfahren nach einem oder mehreren der vorhergehenden Ansprüche, **dadurch gekennzeichnet**, daß die Haftvermittlungsschicht eine Dikke von 5 bis 500 nm aufweist.

9. Beschichteter Gegenstand aus einem hochschmelzenden Metall, **dadurch gekennzeichnet**, daß auf demselben eine Haftvermittlungsschicht aufgedampft ist, und daß auf diese Schicht eine Metallschicht aufgebracht ist.

10. Beschichteter Gegenstand aus einem hochschmelzenden Metall, **dadurch gekennzeichnet**, daß auf demselben eine Haftvermittlungsschicht aufgedampft ist, und daß auf diese Schicht eine Keramikschicht aufgebracht ist.

11. Beschichteter Gegenstand aus Niob, **dadurch gekennzeichnet**, daß auf demselben als Haftvermittlungsschicht eine 50 bis 200 nm dicke Titan- oder Zirkonschicht aufgedampft ist, und daß auf diese Schicht eine Gold- oder Platinschicht aufgebracht ist.

12. Beschichteter Gegenstand aus Niob, **dadurch gekennzeichnet**, daß auf demselben als Haftvermittlungsschicht eine Niobschicht aufgedampft ist, und daß auf diese Schicht eine Goldschicht aufgebracht ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 9, Nr. 12 (C-261)[1735], 18. Januar 1985; & JP-A-59 162 272 (KAGAKUGIJUTSUCHO KINZOKU ZAIRYO KENKYUSHO) 13-09-1984 * Insgesamt * | 1-3,6,7 ,10 | C 23 C 14/02 C 23 C 28/00 |
| X | CHEMICAL ABSTRACTS, Band 102, Nr. 4, Januar 1985, Seite 366, Zusammenfassung Nr. 30470v, Columbus, Ohio, US; & JP-A-59 162 272 (NATIONAL RESEARCH INSTITUTE FOR METALS) 13-09-1984 * Insgesamt * | 1-3,6 | |
| X | BE-A- 698 304 (IMPERIAL METAL INDUSTRIES) * Seite 1, Zeilen 1-4; Seite 2, Zeilen 16-22; Seite 3, Zeilen 2-6; Ansprüche 1-10 * | 1-3,6,7 ,10 | |
| X | US-A-2 993 264 (H.E. GRENOBLE) * Spalte 1, Zeilen 53-59; Spalte 2, Zeilen 45-48,60-72; Spalte 3, Zeilen 27-67; Spalte 14, Zeilen 29-40 * | 1-3,5 | RECHERCHIERTE SACHGEBIETE (Int. Cl.5) C 23 C |
| X | JOURNAL OF VACUUM SCIENCE & TECHNOLOGY A, Band 3, Nr. 6, "Second Series", November/Dezember 1985, Seiten 2650-2654, American Vacuum Society, New York, NY, US; M. FUKUTOMI et al.: "Effect of an intermediate tungsten layer on thermal properties of TiC coatings ion plated onto molybdenum" * Seite 2650, Absatz IIA * -/- | 1-3,7 | |

Der vorliegende Recherchenbericht wurde für alle Patentansprüche erstellt

| Recherchenort | Abschlußdatum der Recherche | Prüfer |
|---|---|---|
| DEN HAAG | 11-10-1989 | JOFFREAU P.O. |

EPO FORM 1503 03.82 (P0403)

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-2 854 739 (K.M. BARTLETT et al.) * Spalte 2, Zeilen 21-24; Spalte 3, Zeilen 45-52; Spalte 5, Zeilen 2-23; Spalte 6, Zeilen 19-28; Anspruch * --- | 1-3,7 | |
| A | FR-A-2 579 997 (PRECI-COAT S.A.) * Seite 2, Zeilen 26-37; Seite 3, Zeilen 1-3,14-18; Ansprüche 1,3-6 * --- | 1,3,5-10 | |
| A | US-A-4 305 998 (B.A. MANTY et al.) * Zusammenfassung; Spalte 3, Zeilen 52-61; Spalte 4, Zeilen 16-32; Ansprüche 1,2 * --- | 1,3,5,7,9 | |
| A | EP-A-0 200 088 (FRIED. KRUPP GmbH) * Zusammenfassung; Seite 3, Zeilen 23-29; Seite 7, Zeilen 1-10; Seite 8, Zeilen 22-31 * --- | 1,3,6,7,10 | |
| A | DE-A- 675 731 (B. BERGHAUS) * Seite 1, Zeilen 43-56; Seite 2, Zeilen 18-21,59-67,89-94; Ansprüche 1,3 * ----- | 1,3,5,7,9 | RECHERCHIERTE SACHGEBIETE (Int. Cl.5) |

Der vorliegende Recherchenbericht wurde für alle Patentansprüche erstellt

| Recherchenort | Abschlußdatum der Recherche | Prüfer |
|---|---|---|
| DEN HAAG | 11-10-1989 | JOFFREAU P.O. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
...........................................................................
& : Mitglied der gleichen Patentfamilie, übereinstimmendes Dokument

EPO FORM 1503 03.82 (P0403)